# EUROPEAN PATENT APPLICATION

(11) **EP 4 509 643 A1**
(43) Date of publication of application: **19.02.2025**
(21) Application number: 22951460.9
(22) Date of filing: 19.07.2022
(51) Int. Cl.: C25D 11/02, C25D 11/26, C23C 14/22, C23C 4/06, C23C 4/00, C23C 4/12, G04B 19/06

(54) **SURFACE MODIFICATION METHOD, COLOR CHANGE METHOD, AND ARTICLE**

(71) Applicant: Dailywin Watch Products Mfg Ltd., New Territories, Hong Kong (HK); Dongguan Dailywin Watch Co., Ltd., Dongguan, Guangdong 523701 (CN)
(72) Inventor: CHONG, Lung Sam, Hong Kong (CN)
(74) Representative: Schmitt-Nilson Schraud Waibel Wohlfrom Patentanwälte Partnerschaft mbB
(86) International application number: PCT/CN2022/106571
(87) International publication number: WO 2024/016182

(57) **Abstract**

A method for surface modification, comprising the following steps: a) providing a first substrate comprising a metal material; b) forming a colored precursor layer on the first substrate by means of vapor deposition, such that the colored precursor layer uses a non-planar contour of the first substrate so as to form a combined substrate with the first substrate; and c) converting a colored precursor in at least one predetermined portion of the colored precursor layer into a light deflection agent to form a modified layer exhibiting a preferred color. A method for changing the color of an article. There is also provided an article comprising a seamlessly bonded substrate.

## Description

### TECHNICAL FIELD

The present disclosure relates to a novel method for surface modification, and particularly, but not exclusively, to a method for modifying a substrate with a colored precursor. The present disclosure further relates to a method of changing a color of an article. The present disclosure further relates to an article, in particular, but not exclusively, to an article including a colored precursor.

### BACKGROUND

Decorative articles such as dressing up accessories, watches, spectacle frames, and ornaments have long existed in the human history. Such articles are generally configured to enhance the beauty or status of the wearer or a particular object in order to attract public attention. Therefore, decorations are generally brightly colored and made of metallic materials, especially aluminum, copper, brass, and stainless steel. Typically, after a substrate is treated with electroplating for corrosion protection, the substrate is then subjected to color modification to obtain a desired color.

When the substrate is copper, brass, or stainless steel, a layer of precious metals such as gold, platinum, palladium, and rhodium can be plated by electroplating or physical vapor deposition (PVD) (such as ion plating) to produce colors from gold, platinum, and rose gold, as well as blue, brown, and black. However, it is unlikely to obtain colors such as green, violet/purple, orange, iridescence, or color gradient through the above modification methods.

When the substrate is aluminum, a variety of colors can be obtained, but these colors are actually a phenomenon dyeing the aluminum after anodic oxidation. This type of modification generally lacks a metallic effect, making the decoration dull. Additionally, a low density of aluminum makes the ornaments lack a sense of weight, further reducing the appeal/impression of aluminum ornaments.

Therefore, there is still a great need for a novel method. The novel method can not only modify the surface of an article (especially the surface of a decorative article) to obtain a wide range of colors that basically cover the visible spectrum, but also maintain inherent characteristics of the article, such as metallic effect and sense of weight.

### SUMMARY

In a first aspect, the present disclosure provides a method for surface modification, including the following steps:
a) providing a first substrate including a metallic material;
b) forming a colored precursor layer on the first substrate by vapor deposition (VD), such that the colored precursor layer uses a non-planar contour of the first substrate to form a combined substrate with the first substrate; and
c) converting a colored precursor in at least one predetermined portion of the colored precursor layer into a light deflection agent to form a modified layer exhibiting a preferred color.

Optionally, the colored precursor layer has a predetermined thickness.

Optionally, the predetermined thickness is at least approximately 1 µm.

Optionally, the colored precursor in the at least one predetermined portion of the colored precursor layer in step c) is converted into the light deflection agent by anodic oxidation.

Optionally, the anodic oxidation includes oxidizing the colored precursor into a colored precursor oxide.

Optionally, the anodic oxidation is conducted for at least 1 min.

Optionally, the anodic oxidation is conducted at a voltage of approximately 10 V to approximately 150 V.

Optionally, the anodic oxidation is conducted at approximately 20°C to approximately 90°C.

Optionally, the VD is selected from the group consisting of radio frequency magnetron sputtering (RFMS) and plasma-enhanced chemical vapor deposition (PECVD).

Optionally, the colored precursor is selected from the group consisting of niobium, tantalum, and a combination thereof.

Optionally, the modified layer includes the light deflection agent covering an unconverted colored precursor.

Optionally, the light deflection agent and the colored precursor are at a thickness ratio of approximately 90:10 to approximately 60:40.

Optionally, the preferred color is any one selected from the group consisting of green, purple, orange, iridescence, and a color gradient.

Optionally, the method further includes forming the first substrate by electroplating the metallic material on another metallic material.

Optionally, the method further includes forming the first substrate by plating the metallic material on a non-metallic material.

Optionally, the plating is conducted by electroless plating.

Optionally, the metallic material is selected from the group consisting of stainless steel, brass, copper, titanium, aluminum, palladium, cobalt, an alloy including the titanium and the aluminum, an alloy including the palladium and the cobalt, and a combination thereof.

Optionally, the non-metallic material is selected from the group consisting of a wood material, a plastic, a carbonaceous material, and a combination thereof.

Optionally, the wood material is a wood composite.

Optionally, the plastic is selected from the group consisting of acrylonitrile butadiene styrene (ABS), polyethylene (PE), polypropylene (PP), polyvinyl chloride (PVC), polylactic acid (PLA), and a combination thereof.

Optionally, the carbonaceous material is selected from the group consisting of graphite, carbon fiber, carbon cloth, carbon sheet, and a combination thereof.

In a second aspect, the present disclosure provides a method for changing a color of an article, including the following steps:
a) providing an article including a first substrate, where the first substrate includes a metallic material;
b) depositing a colored precursor layer on the first substrate by VD, such that the colored precursor layer uses a non-planar contour of the first substrate to form a combined substrate with the first substrate; and
c) converting a colored precursor in at least one predetermined portion of the colored precursor layer into a light deflection agent to form a modified layer exhibiting a preferred color.

Optionally, the colored precursor layer has a predetermined thickness of at least approximately 1 µm.

Optionally, the colored precursor in the at least one predetermined portion of the colored precursor layer in step c) is converted into the light deflection agent by anodic oxidation.

Optionally, the anodic oxidation includes oxidizing the colored precursor into a colored precursor oxide.

Optionally, the anodic oxidation is conducted for at least 1 min.

Optionally, the anodic oxidation is conducted at a voltage of approximately 10 V to approximately 150 V.

Optionally, the anodic oxidation is conducted at approximately 20°C to approximately 90°C.

Optionally, the VD is selected from the group consisting of radio frequency magnetron sputtering (RFMS) and plasma-enhanced chemical vapor deposition (PECVD).

Optionally, the colored precursor is selected from the group consisting of niobium, tantalum, and a combination thereof.

Optionally, the modified layer includes the light deflection agent covering an unconverted colored precursor.

Optionally, the light deflection agent and the colored precursor are at a thickness ratio of approximately 90:10 to approximately 60:40.

Optionally, the preferred color is any one selected from the group consisting of green, purple, orange, iridescence, and a color gradient.

Optionally, the method further includes forming the first substrate by electroplating the metallic material on another metallic material.

Optionally, the method further includes forming the first substrate by plating the metallic material on a non-metallic material.

Optionally, the plating is conducted by electroless plating.

Optionally, the metallic material is selected from the group consisting of stainless steel, brass, copper, titanium, aluminum, palladium, cobalt, an alloy including the titanium and the aluminum, an alloy including the palladium and the cobalt, and a combination thereof.

In a third aspect, the present disclosure provides an article, including:
a first substrate having a non-planar contour; and
a second substrate deposited on the first substrate, where the second substrate uses the non-planar contour of the first substrate to form a seamlessly bonded substrate with the first substrate;
the second substrate includes a colored precursor layer covering the first substrate; and
a colored precursor of the colored precursor layer is selected from the group consisting of niobium, tantalum, and a combination thereof.

Optionally, the colored precursor layer has a substantially uniform thickness.

Optionally, the colored precursor layer has a predetermined thickness of at least approximately 1 µm.

Optionally, the second substrate further includes a colored precursor oxide layer covering the colored precursor layer.

Optionally, the colored precursor layer and the colored precursor oxide layer are at a thickness ratio of approximately 90:10 to approximately 60:40.

Optionally, the article has a color selected from the group consisting of green, purple, orange, iridescence, and a color gradient.

Optionally, the article includes a watch, jewelry, and a spectacle frame.

Optionally, the second substrate is deposited on the first substrate by physical vapor deposition (PVD) or chemical vapor deposition (CVD).

### BRIEF DESCRIPTION OF THE DRAWINGS

Embodiments of the present disclosure will now be described by way of examples with reference to the accompanying drawings, in which:

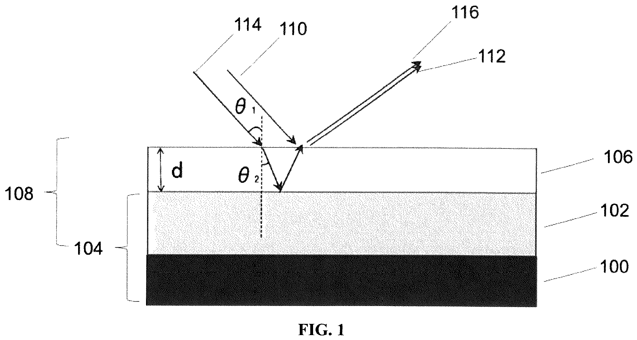

FIG. 1 shows a schematic diagram of film interference on the first substrate prepared according to an example of the present disclosure; where d represents a thickness of the light deflection agent of the modified layer; θ₁ represents an incident light angle of the light deflection agent; and θ₂ represents a refraction angle of light at a boundary between the light deflection agent in the modified layer and the colored precursor.

### DETAILED DESCRIPTION OF THE EMBODIMENTS

Unless otherwise specified, all tests herein are conducted under standard conditions (including test temperature at room temperature (approximately 25°C), sea level pressure (1 atm), pH=7), and all measurements are in metric units. Furthermore, it should be understood that all percentages, ratios, etc. herein are by weight unless otherwise specifically stated. Also, the material compounds, chemicals, etc. described herein are generally commercial and/or industry standard articles available from various suppliers around the world.

Additionally, it is to be understood that the wording and terminology used herein are for the purpose of description and should not be regarded as limiting. Degree terms such as "substantially" or "approximately" are understood by those skilled in the art to refer to a reasonable range outside the given value, such as typical tolerances associated with the manufacture, assembly, and use of the described embodiments.

The words "example" or "exemplary" are used herein to serve as an example, instance, or illustration. Any aspect or design described as "exemplary" is not necessarily to be construed as preferred or advantageous over other aspects or designs. In contrast, using the words "example" or "exemplary" is intended to present the concept in a concrete way. As used in the present disclosure, the term "or" is intended to mean an inclusive "or" rather than an exclusive "or". That is, unless specified otherwise, or clear from the context, "X uses A or B" is intended to mean any of the natural inclusive permutations. That is, if X uses A; X uses B; or X uses both A and B, then "X uses A or B" holds true in any of the above cases.

Transition metals such as niobium and tantalum belong to Group V of the periodic table. These metals are typically grey in color and have properties similar to those of aluminum and titanium, in that they can form oxide layers of different colors after anodic oxidation. These metals also have high melting points of at least approximately 2,000°C, making them extremely suitable for high-temperature alloy applications. However, due to their high melting points, niobium and tantalum are considered extremely difficult to process, especially when reshaping into different shapes or forming uniform coatings to suit specific decorative purposes. Therefore, these metals are rarely used in the manufacture of decorative products or as additives to decorative products.

Without being limited by theory, the inventors have devised a method through their own research, trials, and experiments. The method can be used to modify a surface including a metallic material (e.g., a surface of a decorative article/object), such that the article/object may exhibit a desired/preferred color. In particular, the method can utilize niobium and/or tantalum as colored precursors to modify the surface containing metallic material and change its color. In the specific examples described herein, the method can change a color of the metallic material to any one of green, violet (or purple), orange, iridescence, or a color gradient. In addition, the inventors have also found that the metallic material modified by the method described in this application has physical properties that can pass one or more of the following tests: UV test NIHS 96-50, artificial sweat test ISO 3160-2-2003, adhesion test ISO 4524/5 (SECTION 3), and wear resistance test ISO23160:2001.

According to the present disclosure, a method for surface modification is provided. The method is particularly suitable for modifying a surface including a metallic material to change its appearance from one color to another (desired/preferred) color. The method includes the following steps:
a) providing a first substrate including a metallic material;
b) forming a colored precursor layer on the first substrate by VD (such as PVD or CVD), such that the colored precursor layer uses a non-planar contour of the first substrate to form a combined substrate with the first substrate; and
c) converting a colored precursor in at least one predetermined portion of the colored precursor layer into a light deflection agent to form a modified layer exhibiting a preferred color.

The method starts with step a), including: providing a first substrate including a metallic material. The first substrate may be a substrate substantially made of a metallic material or made of a metallic material. For example, the first substrate may have at least 90 wt%, approximately 90 wt% to approximately 100 wt%, approximately 95 wt% to approximately 100 wt%, approximately 97 wt% to approximately 99 wt%, approximately 98 wt% to approximately 100 wt%, approximately 99 wt%, or approximately 100 wt% by weight content of the metallic material. In an example, the first substrate may have a weight content of approximately 99 wt% or approximately 100 wt% of the metallic material, that is, the first substrate is substantially entirely made of the metallic material or entirely made of the metallic material. The first substrate may be made of one or more metallic materials.

In an example, the first substrate may be made of a single metallic material. For example, the first substrate may be a layered structure having a single layer of a metallic material.

In another example, the first substrate may be made of two or more metallic materials. For example, the first substrate may be a layered structure having two or more layers of a metallic material, where each layer has a metallic material that is the same as or different from each other, such as formed by electroplating one metallic material on another metallic material.

The metallic material may be selected from the group consisting of stainless steel, brass, copper, titanium, aluminum, palladium, cobalt, an alloy including the titanium and the aluminum, an alloy including the palladium and the cobalt, and a combination thereof. In particular, the metallic material may be selected from the group consisting of stainless steel, brass, copper, and an alloy containing palladium and cobalt.

In an example, the first substrate can be formed by electroplating copper on stainless steel to form an electroplated base layer approximately 2 µm to approximately 15 µm thick, and then electroplating palladium and cobalt on the copper to form a (palladium-cobalt) alloy layer approximately 0.25 µm thick.

As known to those skilled in the art, the electroplating may have at least the following typical steps:
- immersing the metallic material in a strike plating solution to allow strike plating; and
- activating the metallic material and immersing in an electrolyte to allow electroplating.

The strike plating solution may be an alkaline solution including components such as cuprous cyanide, sodium cyanide, and sodium carbonate.

The electrolyte may be configured as a solution having a salt of a metal according to a target metal for electroplating. For example, when a target metal for electroplating is copper, the electrolyte may be a solution including copper sulfate. For another example, when the target metal for electroplating is a palladium-cobalt alloy, the electrolyte may be a solution having a specific palladium-to-cobalt concentration ratio (such as palladium ions and cobalt ions at a concentration ratio of approximately 80 g/L: approximately 20 g/L). Those skilled in the art will appreciate that the above solution can be prepared as required or obtained from the market.

Optionally, water washing and pure water washing are conducted between each of the above steps.

In an alternative example, the first substrate may be provided by a step of plating a metallic material on a non-metallic material to form the first substrate. That is, the first substrate can have at least 5 wt%, at least 10 wt%, at least 15 wt%, at least 20 wt%, at least 25 wt%, at least 30 wt%, at least 35 wt%, at least 40 wt%, at least 45 wt%, at least 50 wt%, at least 55 wt%, at least 60 wt%, approximately 60 wt% to approximately 70 wt%, approximately 65 wt% to approximately 70 wt%, approximately 65 wt% to approximately 68 wt%, or approximately 65 wt% to approximately 69 wt% by weight content of the metallic material located on the non-metallic material. In particular, the plating is conducted by electroless plating. The terms "electroless plating," "chemical plating," and "autocatalytic plating" are understood in the art as referring generally to a method of plating or producing a metal coating on a material by the autocatalytic chemical reduction of metal cations in a liquid bath, as opposed to electroplating processes in which the reduction is accomplished by an externally generated electric current.

The non-metallic material may be selected from the group consisting of a wood material, a plastic, a carbonaceous material, and a combination thereof.

In an example, the non-metallic material may be a wood material, in particular a wood composite, or preferably a wood plastic composite. The term "wood plastic composite" generally refers to a composite made of wood fiber and/or wood meal and a thermoplastic selected from the group consisting of PE, PP, PVC, PLA, and combinations thereof.

In an example, the non-metallic material may be a plastic, which is selected from the group consisting of ABS, PE, PP, PVC, PLA, and combinations thereof.

In an example, the non-metallic material may be a carbonaceous material that is selected from the group consisting of graphite, carbon fiber, carbon cloth, carbon sheet, and combinations thereof.

In an example, the first substrate is made of a non-metallic material and two or more metallic materials, and the plating of the metallic materials can be formed by different processes. For example, a metallic material is plated on the non-metallic material by electroless plating, and then another metallic material is plated on the previous metallic material (i.e., on the metallic material plated on the non-metallic material) by electroplating. In one example, copper is plated on ABS plastic by an electroless copper plating process to form an approximately 2 µm to approximately 15 µm thick electroplated base layer, and then palladium and cobalt are plated on the electroless plating copper by an electroplating process to form a palladium-cobalt alloy layer of approximately 0.25 µm thick.

The electroless plating may be conducted according to any standard procedure in the art. For example, in a typical electroless plating process, the method may further include the following steps before chemical plating:
i) removing grease from the non-metallic material;
ii) etching the non-metallic material in an etching solution;
iii) activating the non-metallic material in a catalytic solution; and
iv) accelerating the non-metallic material in an accelerating solution.

Step i) is a cleaning step, which may specifically include the following procedures:
- optionally ultrasonically degreasing the non-metallic material in an organic bath, such as an acetone bath or a surfactant bath for approximately 10 min;
- immersing the non-metallic material in an alkaline solution at an elevated temperature, such as approximately 60°C for approximately 10 min;
- rinsing the non-metallic material with water and/or pure water; and
- optionally repeating step i) at least once.

The alkaline solution may include sodium hydroxide, trisodium phosphate dodecahydrate, and combinations thereof. Each of them may have a concentration of approximately 0.25 M to approximately 0.4 M.

Step ii) may in particular include the following procedures:
- immersing the non-metallic material obtained after step i) in an etching solution at an elevated temperature, such as approximately 60°C for a predetermined time, such as approximately 20 min; and
- immersing a resulting etched non-metallic material in a neutralizing solution to remove any undesirable etchant/oxide remaining on the surface.

The etching solution may be an acidic solution including, for example, hydrochloric acid, chromium trioxide, sulfuric acid, nitric acid, and combinations thereof. Each of them may have a concentration of approximately 1.5 M to approximately 4.0 M. The concentration of the acidic solution is optionally carefully controlled to only micro-etch the non-metallic material. The neutralizing solution may be the same as the alkaline solution in step i).

Step iii) may in particular include the following steps:
- immersing the non-metallic material obtained after step ii) in a catalytic solution, where the catalytic solution may include an acid and a catalyst. The acid can be hydrochloric acid or sulfuric acid at a concentration of, for example, approximately 0.8 M to approximately 1.2 M. The catalyst can be selected from palladium chloride, tin chloride, and combinations thereof, where the catalyst can have a concentration of, for example, approximately 1 µM to approximately 2 µM.

Step iv) may in particular include the following steps:
- immersing the non-metallic material obtained after step iii) in an accelerating solution, where the accelerating solution may include a catalyst that can oxidize tin on the non-metallic material, such as one or more of the following: sodium chlorite, sodium dichloroisocyanurate, hydrogen peroxide, sodium hypochlorite, sodium chlorate, potassium permanganate, sodium perborate. The accelerating solution can have a concentration of, for example, approximately 0.1 M to approximately 0.2 M.

The electroless plating may be conducted by immersing an accelerated non-metallic material (i.e., the non-metallic material obtained after step iv) into a reaction solution. The reaction solution may be an alkaline solution containing sodium hydroxide, potassium hydroxide, or the like. The reaction solution may further include a metal salt of the target metal, a reducing agent, and a stabilizer. For example, when a target metal of the electroless plating is copper, the reaction solution may include copper sulfate, formaldehyde, ethylenediaminetetraacetic acid (EDTA), and sodium hydroxide.

Optionally, the electroless plating layer may be thickened by an electroplating process before the palladium-cobalt alloy electroplating process as required. For example, before conducting the palladium-cobalt alloy electroplating process, a layer of electroplated copper with a predetermined thickness may be further plated on the electroless copper by the electroplating copper process.

Optionally, water washing and pure water washing are conducted between each of the above steps.

The first substrate is preferably a substrate having a non-planar contour. The non-planar contour of the first substrate may be in any form or shape depending on the particular demands. For example, the first substrate can be made into a vehicle part such as a frame, a door, a bumper and/or have its contour; a decorative object such as a decorative ball, a necklace, earrings, a watch, jewelry, a glasses frame, and/or have its contour; a key, a door handle and/or have its contour. As a specific example, the first substrate is a decorative item, such as a watch, jewelry, and spectacle frames. Optionally, the first substrate may be subjected to appropriate processing, grinding, polishing, cleaning with a degreasing agent, and the like.

After providing/preparing the first substrate, the method moves to step b), including: forming a colored precursor layer on the first substrate by PVD or CVD, such that the colored precursor layer uses a non-planar contour of the first substrate to form a combined substrate with the first substrate. The terms "PVD" and "CVD" generally describe vacuum deposition methods that can be used to create thin films and coatings on certain materials/substrates. Such PVD generally involves the change of material from a condensed phase to a vapor and then back to a thin film condensed phase. The CVD generally involves chemical reactions and/or chemical decompositions on the surface of a specific material/substrate to produce a deposited thin film or coating.

In particular, PVD may involve magnetron sputtering (MS) (such as RFMS) or radio frequency ion plating (RFIP). As known to those skilled in the art, an MS apparatus includes a vacuum chamber and one or more targets arranged in the vacuum chamber, as well as a cathode and an anode connected to a power source (DC or AC), and a substrate can be placed in the vacuum chamber near the anode to sputter and deposit the target material on the substrate by single-target sputtering, multiple-target sequential sputtering, or co-sputtering. Prior to or during sputtering, the material/substrate to be coated may be placed in the MS apparatus and heated from approximately 25°C to approximately 350°C.

In an example, the sputtering uses a target material including or consisting of a colored precursor (e.g., a pure metal niobium target), argon as a process gas is injected at a pressure of 5×10⁻¹ Pa into a vacuum chamber maintained at a vacuum degree of 5×10⁻⁶ mbar, and the MS apparatus adopts an RF power of approximately 90 W to approximately 200 W (preferably 150 W) and a DC bias of approximately 120 V to approximately 200 V (preferably 150 V) to allow sputtering within approximately 2 h to approximately 4 h (preferably 2 h) to ensure that a desired thin film or coating is obtained.

CVD may involve PECVD, which has the advantages of high deposition rate, desirable film quality, and the film being not prone to cracking. As known to those skilled in the art, a PECVD apparatus includes a vacuum chamber, electrodes and gas pipelines arranged in the vacuum chamber, and a substrate may be placed in the vacuum chamber to deposit plasma generated from the gas on the substrate.

In an example, in order to deposit the desired colored precursor on the substrate, the PECVD apparatus also includes a precursor container for containing the colored precursor or a compound containing the colored precursor, where the precursor container is connected to a mass flow controller to control the amount of a carrier gas added into the colored precursor or the compound containing the colored precursor. In an example, to deposit niobium on a substrate, niobium pentachloride is added into argon as a carrier gas, and hydrogen is used as a reactive gas. During the deposition, the material/substrate to be coated is maintained at approximately 700°C, a vacuum degree in the vacuum chamber is maintained at 5×10⁻⁶ mbar, and the deposition is conducted for approximately 60 min to ensure the desired thin film or coating.

The colored precursor layer deposited on the first substrate can have a predetermined thickness of at least approximately 1 µm, approximately 1 µm to approximately 5 µm, approximately 1 µm to approximately 4 µm, approximately 1.5 µm to approximately 4 µm, approximately 1.5 µm to approximately 3.5 µm, or particularly 3 µm.

In an example, the colored precursor may be selected from the group consisting of niobium, tantalum, and a combination thereof. The inventors have found that forming such a colored precursor by means of PVD or CVD is particularly advantageous. It can be appreciated that by PVD or CVD, the colored precursor can be deposited/attached to the first substrate in the form of particles rather than as a whole block or piece of material. Thus, the colored precursor layer formed in this form/process may easily adopt any contour, and in particular even if the first substrate has a non-planar contour, the colored precursor can still form a substantially uniform or uniform layer on the substrate and produce a seamlessly bonded substrate therewith. It is understandable that this effect can hardly be achieved by simply adhering the colored precursor to the substrate, especially when the typical melt-reshape method in the prior art cannot be used to process such a colored precursor, for example, when the colored precursor contains a material with a high melting point, such as niobium, tantalum and combinations thereof. It is also advantageous that, by PVD or CVD, a minimum thickness of, for example, approximately 1 µm is sufficient to allow the method to proceed with the subsequent steps of the method. Examples illustrating the advantages of this method will be disclosed in a later section of the present disclosure.

Step c) includes converting a colored precursor in at least one predetermined portion of the colored precursor layer into a light deflection agent to form a modified layer exhibiting a preferred color. As used herein, the term "light deflection agent" refers to a compound or layer of such a compound that allows film interference to occur. The term "film interference" generally refers to the phenomenon that incident light waves reflected from the upper and lower boundaries of a thin film interfere with each other to form new waves, preferably due to constructive interference (i.e., when the optical path difference is equal to an integer multiple of the wavelength of the light).

For example, FIG. 1 shows a schematic diagram of the first substrate prepared according to an example of the present disclosure. The first substrate 100 may be a first substrate 100 made of two or more metallic materials as described above, such as a first substrate 100 having an electroplated base layer and an alloy layer (not shown) as described above. A layer of colored precursor 102 may be deposited on the first substrate 100 by PVD or CVD to form a seamlessly bonded substrate 104 with the first substrate. The first substrate 100 further includes a light deflection agent (layer) 106 converted from the colored precursor 102, which covers the colored precursor and forms a modified layer 108. As shown in the figure, an incident light wave 110 is directly reflected by the upper boundary of the light deflection agent 106 to form a reflected light wave 112; while an incident light wave 114 is refracted by the light deflection agent 106 and then reflected by the colored precursor 102 (i.e., reflected at the lower boundary of the light deflection agent) to form a new light wave 116. When light waves 112 and 116 are in phase, constructive interference occurs.

The colored precursor in the one predetermined portion of the colored precursor layer in step c) may be converted into a light deflection agent by anodic oxidation, in particular anodic oxidation involving oxidation of the color precursor to its oxide. The anodic oxidation can be conducted by any standard electroplating apparatus, such as an electrochemical cell/station/tank. For example, in a typical process, the combined substrate (i.e., the first substrate on which the colored precursor is deposited) may serve as an anode and may be electrically connected to a cathode (such as a cathode made of platinum) to allow the anodic oxidation.

When conducting the anodic oxidation, a voltage may be applied to the device after immersing the cathode and combined substrate in an acidic or alkaline electrolyte. Depending on the preferred color, e.g. a single color or a mixture of colors (e.g. a color gradient), anodic oxidation of the colored precursor can be conducted by immersing the assembled substrate a portion at a time into an anodic oxidation electrolyte to allow anodic oxidation in a portion-by-portion manner. Alternatively, it can be done in a one-shot manner by immersing the entire assembled substrate in the anodic oxidation electrolyte.

The anodic oxidation may be conducted at a predetermined voltage, temperature, and/or electrolyte for a predetermined time to form a modified layer that may exhibit a specific or preferred color.

In an example, the anodic oxidation can be conducted at a voltage of approximately 10 V to approximately 150, approximately 10 V to approximately 151 V, approximately 15 V to approximately 150 V, approximately 15 V to approximately 151 V, approximately 18 V to approximately 150 V, approximately 19 V to approximately 151 V, or approximately 19 V to approximately 150 V, preferably at a voltage of 20 V to 150 V. In an example, anodic oxidation at a voltage of 20 V can produce a coloring effect, and the higher the voltage and the longer the time, the thicker the modified layer, but the thickness stops increasing after reaching a certain value.

In an example, the anodic oxidation can be conducted at approximately 20°C to approximately 90°C, approximately 20°C to approximately 89°C, approximately 25°C to approximately 90°C, approximately 30°C to approximately 90°C, approximately 35°C to approximately 89°C, approximately 40°C to approximately 91°C, approximately 40°C to approximately 90°C, approximately 45°C to approximately 89°C, or approximately 49°C to approximately 89°C, preferably 50°C to 90°C.

In an example, the anodic oxidation can be conducted for at least 1 min, approximately 1 min to approximately 180 min, approximately 1 min to approximately 120 min, approximately 1 min to approximately 90 min, approximately 1 min to approximately 75 min, approximately 1 min to approximately 70 min, approximately 1.5 min to approximately 70 min, approximately 1.5 min to approximately 65 min, preferably approximately 1 min to approximately 60 min.

The modified layer may include a light deflection agent covering an unconverted colored precursor. That is, a portion of the colored precursor after anodic oxidation is converted into a light deflection agent and covers the unconverted color precursor.

In an example, the light deflection agent in the modified layer may have a thickness of approximately 0.1 µm to approximately 0.5 µm, 0.15 µm to approximately 0.5 µm, 0.15 µm to approximately 0.45 µm, 0.1 µm to approximately 0.4 µm, 0.15 µm to approximately 0.35 µm, 0.15 µm to approximately 0.4 µm, 0.15 µm to approximately 0.28 µm, preferably approximately 0.1 µm to approximately 0.3 µm.

In an example, the light deflection agent and the colored precursor in the modified layer may have a predetermined thickness ratio of approximately 90:10 to approximately 60:40, approximately 9:1 to approximately 6:4, approximately 9:1 to approximately 3:2, or approximately 0.9:0.1 to approximately 0.3:0.2.

In examples where the colored precursor includes a single element, the colored precursor and oxygen in the light deflection agent may have an overall atomic ratio of approximately 20:80 to approximately 80:20, approximately 30:70 to approximately 70:30, and preferably 40:60. For example, in an example where the colored precursor is niobium, the overall atomic ratio of niobium to oxygen (Nb: O) of niobium oxide (i.e., the light deflection agent) may be 40:60. Furthermore, the light deflection agent may contain different oxides (having different oxidation numbers) for the same colored precursor. For example, in one example where the colored precursor is niobium, the light deflection agent may have niobium oxide of approximately 70% NbO, approximately 20% NbO₂, and approximately 10% Nb₂O₅. The ratio of these oxides varies when different voltages are applied. Moreover, the closer to the surface, the higher the proportion of oxygen, thus forming different colors.

The inventors have discovered that the thickness ratio and oxygen ratio as described above may be critical in determining the preferred color to be exhibited. As a specific example, the preferred color is preferably any one selected from the group consisting of green, purple, orange, iridescence, and a color gradient.

Also according to the present disclosure, a method for changing the color of an article, in particular a method for changing the color of an article including a metallic material is provided. The method includes the following steps:
a) providing an article including a first substrate, where the first substrate includes a metallic material;
b) depositing a colored precursor deposited on the first substrate by VD (such as PVD or CVD), such that the colored precursor layer uses a non-planar contour of the first substrate to form a combined substrate with the first substrate; and
c) converting a colored precursor in at least one predetermined portion of the colored precursor layer into a light deflection agent to form a modified layer exhibiting a preferred color.

The method starts from step a), including: providing an article having a first substrate including a metallic material. In an example, the article may include a first substrate made essentially of or made of a metallic material. For example, the first substrate may have at least 90 wt%, approximately 90 wt% to approximately 100 wt%, approximately 95 wt% to approximately 100 wt%, approximately 97 wt% to approximately 99 wt%, approximately 98 wt% to approximately 100 wt%, approximately 99 wt%, or approximately 100 wt% by weight content of the metallic material. In an example, the first substrate may have a weight content of approximately 99 wt% or approximately 100 wt% of the metallic material, that is, the first substrate is substantially made of the metallic material or entirely made of the metallic material. The first substrate may be made of one or more than one metallic material. For example, one metallic material may be electroplated on another metallic material to form the first substrate.

The metallic material may be selected from the group consisting of stainless steel, brass, copper, titanium, aluminum, palladium, cobalt, an alloy including the titanium and the aluminum, an alloy including the palladium and the cobalt, and a combination thereof. In particular, the metallic material may be selected from the group consisting of stainless steel, brass copper, and an alloy containing the palladium and cobalt.

In an alternative example, the first substrate may be provided by the step of plating one or more metallic materials on a non-metallic material to form the first substrate, and the plating of two or more metallic materials may be formed by different processes, as described above. That is, the first substrate can have at least 5 wt%, at least 10 wt%, at least 15 wt%, at least 20 wt%, at least 25 wt%, at least 30 wt%, at least 35 wt%, at least 40 wt%, at least 45 wt%, at least 50 wt%, at least 55 wt%, at least 60 wt%, approximately 60 wt% to approximately 70 wt%, approximately 65 wt% to approximately 70 wt%, approximately 65 wt% to approximately 68 wt%, or approximately 65 wt% to approximately 69 wt% by weight content of the metallic material located on the non-metallic material. In particular, the plating of the non-metallic material is conducted by electroless plating as defined herein.

The non-metallic material may be selected from the group consisting of a wood material, a plastic, a carbonaceous material, and a combination thereof.

In an example, the non-metallic material may be a wood material, in particular a wood composite, or preferably a wood plastic composite. The term "wood plastic composite" generally refers to a composite made of wood fiber and/or wood meal and a thermoplastic selected from the group consisting of PE, PP, PVC, PLA, and combinations thereof.

In an example, the non-metallic material may be a plastic, which is selected from the group consisting of ABS, PE, PP, PVC, PLA, and combinations thereof.

In an example, the non-metallic material may be a carbonaceous material that is selected from the group consisting of graphite, carbon fiber, carbon cloth, carbon sheet, and combinations thereof.

The first substrate is preferably a substrate having a non-planar contour. The non-planar contour of the first substrate may be of any form or shape depending on the type of article. For example, when the article is a decorative object, such as a decorative ball, a necklace, earrings, a watch, jewelry, or a spectacle frame, the first substrate may be the decorative ball, necklace, earrings, watch, jewelry, spectacle frame, and/or have a contour thereof. In one example, the article may be any of a watch, jewelry, or spectacle frames, and the first substrate may be any of these articles and/or have the contours thereof. Optionally, the article may be subjected to appropriate processing, grinding, polishing, cleaning with a degreasing agent, and the like.

After providing/preparing the article, the method moves to step b), including: forming a colored precursor layer on the first substrate by PVD or CVD, such that the colored precursor layer uses a non-planar contour of the first substrate to form a combined substrate with the first substrate. In particular, PVD may involve magnetron sputtering (MS) (such as RFMS) or radio frequency ion plating (RFIP), and the CVD may involve PECVD, as described above.

The colored precursor layer deposited on the first substrate can have a predetermined thickness of at least approximately 1 µm, approximately 1 µm to approximately 5 µm, approximately 1 µm to approximately 4 µm, approximately 1.5 µm to approximately 4 µm, approximately 1.5 µm to approximately 3.5 µm, or particularly 3 µm.

In an example, the colored precursor may be selected from the group consisting of niobium, tantalum, and a combination thereof. As mentioned above, it is advantageous to deposit such a colored precursor (with a high melting point) by PVD or CVD. In a preferred example, the colored precursor is niobium.

Step c) includes converting a colored precursor in at least one predetermined portion of the colored precursor layer into a light deflection agent to form a modified layer exhibiting a preferred color. The colored precursor in the one predetermined portion of the colored precursor layer in step c) may be converted into a light deflection agent by anodic oxidation, in particular anodic oxidation involving oxidation of the color precursor to its oxide.

The anodic oxidation may be conducted at a predetermined voltage, temperature, and/or acidic or alkaline electrolyte for a predetermined time and in any standard electroplating apparatus as described above to form a modified layer that may exhibit a specific or preferred color.

In an example, the anodic oxidation can be conducted at a voltage of approximately 10 V to approximately 150, approximately 10 V to approximately 151 V, approximately 15 V to approximately 150 V, approximately 15 V to approximately 151 V, approximately 18 V to approximately 150 V, approximately 19 V to approximately 151 V, or approximately 19 V to approximately 150 V, preferably at a voltage of 20 V to 150 V. In an example, anodic oxidation at a voltage of 20 V can produce a coloring effect, and the higher the voltage and the longer the time, the thicker the modified layer, but the thickness stops increasing after reaching a certain value.

In an example, the anodic oxidation can be conducted at approximately 20°C to approximately 90°C, approximately 20°C to approximately 89°C, approximately 25°C to approximately 90°C, approximately 30°C to approximately 90°C, approximately 35°C to approximately 89°C, approximately 40°C to approximately 91°C, approximately 40°C to approximately 90°C, approximately 45°C to approximately 89°C, or approximately 49°C to approximately 89°C, preferably 50°C to 90°C.

In an example, the anodic oxidation can be conducted for at least 1 min, approximately 1 min to approximately 180 min, approximately 1 min to approximately 120 min, approximately 1 min to approximately 90 min, approximately 1 min to approximately 75 min, approximately 1 min to approximately 70 min, approximately 1.5 min to approximately 70 min, approximately 1.5 min to approximately 65 min, preferably approximately 1 min to approximately 60 min.

The modified layer may include a light deflection agent covering an unconverted colored precursor. That is, a portion of the colored precursor after anodic oxidation is converted into a light deflection agent and covers the unconverted color precursor.

In an example, the light deflection agent in the modified layer may have a thickness of approximately 0.1 µm to approximately 0.5 µm, 0.15 µm to approximately 0.5 µm, 0.15 µm to approximately 0.45 µm, 0.1 µm to approximately 0.4 µm, 0.15 µm to approximately 0.35 µm, 0.15 µm to approximately 0.4 µm, 0.15 µm to approximately 0.28 µm, preferably approximately 0.1 µm to approximately 0.3 µm.

In an example, the light deflection agent and the colored precursor in the modified layer may have a predetermined thickness ratio of approximately 90:10 to approximately 60:40, approximately 9:1 to approximately 6:4, approximately 9:1 to approximately 3:2, or approximately 0.9:0.1 to approximately 0.3:0.2. In examples where the colored precursor includes a single element, the colored precursor and oxygen in the light deflection agent may have an overall atomic ratio of approximately 20:80 to approximately 80:20, approximately 30:70 to approximately 70:30, and preferably 40:60. For example, in an example where the colored precursor is niobium, the overall atomic ratio of niobium to oxygen (Nb: O) of niobium oxide (i.e., the light deflection agent) may be 40:60. Furthermore, the light deflection agent may contain different oxides (having different oxidation numbers) for the same colored precursor. For example, in one example where the colored precursor is niobium, the light deflection agent may have niobium oxide of approximately 70% NbO, approximately 20% NbO₂, and approximately 10% Nb₂O₅. The ratio of these oxides varies when different voltages are applied. Moreover, the closer to the surface, the higher the proportion of oxygen, thus forming different colors.

As described above, the thickness ratio and oxygen ratio as described above may be critical in determining the preferred color to be exhibited. As a specific example, the preferred color is preferably any one selected from the group consisting of green, purple, orange, iridescence, and a color gradient.

Another aspect of the present disclosure relates to an article, including:
a first substrate having a non-planar contour; and
a second substrate deposited on the first substrate, where the second substrate uses the non-planar contour of the first substrate to form a seamlessly bonded substrate with the first substrate;
the second substrate includes a colored precursor layer covering the first substrate; and
a colored precursor of the colored precursor layer is selected from the group consisting of niobium, tantalum, and a combination thereof.

The first substrate may include a metallic material selected from the group consisting of stainless steel, brass, copper, titanium, aluminum, palladium, cobalt, an alloy including the titanium and the aluminum, an alloy including the palladium and the cobalt, and a combination thereof. In particular, the metallic material may be selected from the group consisting of stainless steel, brass, copper, and an alloy containing palladium and cobalt. In an example, the first substrate may be made essentially of or made of a metallic material as defined herein. The first substrate may be made of one or more than one metallic material. For example, one metallic material may be electroplated on another metallic material to form the first substrate. In an alternative example, the first substrate can be a substrate having one or more metallic materials plated on a non-metallic material, such as a non-metallic material selected from the group consisting of wood materials, plastics, carbon materials, and combinations thereof as defined herein, and the plating of two or more metallic materials can be conducted by different processes. The plating may in particular be plating by means of electroless plating as defined herein.

The expression "non-planar contour" generally refers to a shape, form, or contour of an article that does not lie or cannot be confined within a single plane, or in other words, has a three-dimensional quality. In an example, the first substrate may have a contour/shape/form corresponding to the article. For example, the first substrate may have a contour corresponding to an article, which may be a vehicle part such as a frame, door, bumper; an ornament such as a decorative ball, necklace, earrings, watch, jewelry, spectacle frame; a key, door handle. As a specific example, the article may include a watch, jewelry, and spectacle frames.

The first substrate may be deposited with a second substrate that adopts the non-planar contour of the first substrate to form a seamlessly bonded substrate. The second substrate may include a colored precursor layer covering the first substrate. In particular, the colored precursor in the colored precursor layer may be selected from the group consisting of niobium, tantalum, and combinations thereof. In a preferred example, the colored precursor is niobium.

In an example, the colored precursor layer may have a substantially uniform thickness, in particular a predetermined thickness of at least approximately 1 µm, approximately 1 µm to approximately 5 µm, approximately 1 µm to approximately 4 µm, approximately 1.5 µm to approximately 4 µm, approximately 1.5 µm to approximately 3.5 µm, or particularly 3 µm. This substantially uniform thickness is attributable to the manner in which the colored precursor layer is deposited/formed/prepared by PVD or CVD as defined herein, for example by RFMS or PECVD.

As described above, by PVD or CVD, the colored precursor can be deposited on the first substrate in the form of particles that will readily adopt any contour, especially the non-planar contour of the first substrate, forming a substantially uniform or uniform layer on the substrate, and then forming a seamlessly bonded substrate.

The second substrate may further include a colored precursor oxide layer covering the colored precursor layer. In an example, the colored precursor oxide layer may have a thickness of approximately 0.1 µm to approximately 0.5 µm, 0.15 µm to approximately 0.5 µm, 0.15 µm to approximately 0.45 µm, 0.1 µm to approximately 0.4 µm, 0.15 µm to approximately 0.35 µm, 0.15 µm to approximately 0.4 µm, 0.15 µm to approximately 0.28 µm, preferably approximately 0.1 µm to approximately 0.3 µm.

In an example, the colored precursor layer and the colored precursor oxide layer may have a thickness ratio of approximately 90:10 to approximately 60:40, approximately 9:1 to approximately 6:4, approximately 9:1 to approximately 3:2, or approximately 0.9:0.1 to approximately 0.3:0.2.

In examples where the colored precursor includes a single element, the colored precursor and oxygen in the oxide layer may have an overall atomic ratio of approximately 20:80 to approximately 80:20, approximately 30:70 to approximately 70:30, and preferably 40:60. For example, in an example where the colored precursor is niobium, the overall atomic ratio of niobium to oxygen (Nb: O) in the niobium oxide layer may be 40:60. Furthermore, the oxide layer may contain different oxides (having different oxidation numbers) for the same colored precursor. For example, in one example where the colored precursor is niobium, the oxide layer may have approximately 70% NbO, approximately 20% NbO₂, and approximately 10% Nb₂O₅. The ratio of these oxides varies when different voltages are applied. Moreover, the closer to the surface, the higher the proportion of oxygen, thus forming different colors.

The thickness ratio and oxygen ratio as described above may be critical in determining the color of the article. In a specific example, the article may have a color selected from the group consisting of green, purple, orange, iridescence, and a color gradient.

### Example 1 Brass workpiece

### 1. Providing brass workpiece

First, a brass substrate was shaped into the watch case workpiece by, for example, a balancing press working method, and then the watch case workpiece was appropriately ground and polished. After grinding and polishing, the workpiece was cleaned with a degreasing agent to remove surface grease.

### 2. Electrolytic copper process

The workpiece was immersed in a strike plating solution to allow strike plating of alkaline copper, washed with water, and then subjected to a pretreatment process including degreasing, etching to activate the surface of the strike-plated workpiece, and then washed with water. The pretreated workpiece was immersed in an electrolyte to allow acidic copper electroplating under the conditions described in the following table, washed with water, and then dried.

**Table 1 Acidic copper electroplating conditions**

| Electrolyte composition | Copper sulfate: 220 g/L |
|---|---|
| | Sulfuric acid: 60 g/L |
| | Hydrochloric acid: 75 ppm |
| Current density | 4 ASD |
| Electroplating time | 15 min |
| Target thickness | 15 µm |

### 3. Electroplating palladium-cobalt alloy process

The copper-plated workpiece was immersed in the electrolyte to allow palladium-cobalt alloy electroplating under the conditions described in the following table, washed with water, and then dried.

**Table 2 Palladium-cobalt alloy electroplating conditions**

| Electrolyte composition | Palladium: 1.5 g/L |
|---|---|
| | Cobalt: 4 g/L |
| | pH: 8 |
| Current density | 1 ASD |
| Electroplating time | 2 min |
| Target thickness | 0.25 µm |

### 4. PVD of niobium

The brass workpiece that had been electroplated with copper and palladium-cobalt alloy was placed in a vacuum plating machine and RFMS was conducted under the conditions described in the following table, such that a layer of niobium was deposited by PVD on the palladium-cobalt alloy surface of the brass workpiece.

**Table 3 PVD of niobium conditions**

| | |
|---|---|
| Radio-frequency power | 150 W |
| DC bias | 150 V |
| Working temperature | 350°C |
| Vacuum degree | 5×10⁻⁶ mbar |
| Sputtering time | 2 h |
| Target thickness | 3 µm |

### 4. Anodic oxidation

The workpiece after PVD was immersed in an alkaline electrolyte containing sodium bicarbonate (90 g/L), sodium silicate (5 g/L), and EDTA (5 g/L) to allow anodic oxidation at a voltage of 50 V to 80 V and 50°C to 80°C for 2 min to oxidize the niobium layer to obtain a desired color. Results obtained by the above operations were as follows:

**Table 4 Effects of various anodic oxidation treatments on brass workpiece**

| Voltag e (V) | Temp eratur e (°C) | Time (min) | Ratio of each niobium oxide (NbO/NbO₂/Nb₂O₅) (%) | Niobium oxide thickness (µm) | Color | L*/a*/b* |
|---|---|---|---|---|---|---|
| 50 | 80 | 2 | 64.39/27.93/7.68 | 0.15 | Dark yellow | 64/10/22 |
| 70 | | | 70.67/21.63/7.7 | 0.21 | Green | 65/34/31 |
| 90 | | | 71.37/20.64/7.99 | 0.27 | Dark blue | 28/-2.6/-23 |
| 50 | 50 | | 71.23/21.11/7.66 | 0.12 | Dark yellow | 54/-5.3/30 |
| 70 | | | 71.78/20.51/7.72 | 0.20 | Dark blue | 44/-19/-37 |
| 90 | | | 68.46/22.01/9.53 | 0.25 | Yellow green | 65/-14/42 |

The thickness of the coating was measured by SEM, while the composition and proportion of the coating were measured by XPS. The color of the processed workpiece was measured by a colorimeter and expressed as L*a*b* values. Those skilled in the art would appreciate that L*a*b* were values for defining a CIELAB color space, i.e., L* represented perceived brightness, and a* and b* represented the four unique colors of human vision: red, green, blue, and yellow.

### Example 2 ABS material

### 1. Providing ABS workpiece

An ABS material was cut into suitable sizes, and then shaped, polished, and trimmed as needed to obtain a required ABS workpiece.

### 2. Electroless copper plating process

The ABS workpiece was subjected to pretreatment, and the pretreatment included cleaning (degreasing), (micro) etching, neutralization, catalysis, and acceleration as described above, where water washing or pure water washing were conducted between each step. The pretreated ABS workpiece was immersed in a reaction solution for electroless plating under the conditions described in the following table, washed with water, and then dried.

**Table 5 Electroless copper plating conditions**

| Reaction solution component | Copper content: 2.2 g/L |
|---|---|
| | Potassium sodium tartrate: 13 g/L |
| | Formaldehyde: 3 g/L |
| | Sodium hydroxide: 8 g/L |
| | Potassium ferrocvanide: 1 g/L |
| Temperature | 20°C |
| Plating time | 2.5 min |
| Target thickness | 0.1 µm |

### 3. Electroplating palladium-cobalt alloy process

The ABS workpiece after the electroless copper plating was immersed in the electrolyte shown in Table 3 to allow palladium-cobalt alloy electroplating under the conditions in the table, followed by water washing and drying.

### 4. CVD of niobium

The ABS workpiece that had been electroplated with palladium-cobalt alloy was placed in a vacuum plating machine and PECVD was conducted under the conditions described in the following table to form a layer of niobium on the palladium-cobalt alloy surface of the ABS workpiece by CVD.

**Table 6 CVD of niobium conditions**

| | |
|---|---|
| Precursor | Niobium pentachloride (NbCl₅) |
| Carrier gas | Argon |
| Reaction gas | Hydrogen |
| Working temperature | 100 °C |
| Sputtering time | 2 h |
| Target thickness | 3 µm |

### 5. Anodic oxidation

The workpiece after CVD was immersed in an alkaline electrolyte containing sodium bicarbonate (90 g/L), sodium silicate (5 g/L), and EDTA (5 g/L) to allow anodic oxidation at a voltage of 60 V to 80 V and 25°C for 2 min to oxidize the niobium layer to obtain a desired color. Results obtained by the above operations were as follows:

**Table 7 Effects of various anodic oxidation treatments on ABS workpiece**

| Volta ge (V) | Temp eratur e (°C) | Time (min) | Ratio of each niobium oxide (NbO/NbO₂/Nb₂O₅) (%) | Niobium oxide thickness (µm) | Color | L*/a*/b* |
|---|---|---|---|---|---|---|
| 60 | 25 | 1 | 70.63/21.61/7.75 | 205 | Red | 37/47/-35 |
| | | 60 | 64.74/21.12/7.61 | 209 | Purple | 58/-42/-2.6 |
| | | 120 | 69.95/22.49/7.56 | 230 | Blue | 48/-30/-29 |
| | | 180 | 73.27/21.18/5.55 | 238 | Dark blue | 26/-1.8/-24 |
| 80 | | 60 | 71.92/20.55/7.53 | 302 | Green | 69/-38/19 |

The thickness of the coating was measured by SEM, while the composition and proportion of the coating were measured by XPS. The color of the processed workpiece was measured by a colorimeter and expressed as L*a*b* values. Those skilled in the art would appreciate that L*a*b* were values for defining a CIELAB color space, i.e., L* represented perceived brightness, and a* and b* represented the four unique colors of human vision: red, green, blue, and yellow.

Those skilled in the art will appreciate that various changes and/or modifications can be made to the present disclosure shown in the detailed description without departing from the spirit or scope of the present disclosure as broadly described. Accordingly, the described examples of the present disclosure are to be considered in all respects as illustrative and not restrictive.

It should also be appreciated that certain features of the present disclosure, which are, for clarity, described in the context of separate examples, may also be provided in combination in a single example. Conversely, various features of the present disclosure which are, for brevity, described in the context of a single example, may also be provided separately or in any suitable subcombination.

All references specifically cited herein are hereby incorporated by reference in their entirety. However, citation or incorporation of such a reference is not necessarily an admission of its appropriateness, citability, and/or availability as prior art to/against the present disclosure.

## Claims

1. A method for surface modification, comprising the following steps:
a) providing a first substrate comprising a metallic material;
b) forming a colored precursor layer on the first substrate by vapor deposition (VD), such that the colored precursor layer uses a non-planar contour of the first substrate to form a combined substrate with the first substrate; and
c) converting a colored precursor in at least one predetermined portion of the colored precursor layer into a light deflection agent to form a modified layer exhibiting a preferred color.

2. The method according to claim 1, wherein the colored precursor layer has a predetermined thickness.

3. The method according to claim 2, wherein the predetermined thickness is at least approximately 1 µm.

4. The method according to claim 1, wherein the colored precursor in the at least one predetermined portion of the colored precursor layer in step c) is converted into the light deflection agent by anodic oxidation.

5. The method according to claim 4, wherein the anodic oxidation comprises oxidizing the colored precursor into a colored precursor oxide.

6. The method according to claim 4 or 5, wherein the anodic oxidation is conducted for at least 1 min.

7. The method according to any one of claims 4 to 6, wherein the anodic oxidation is conducted at a voltage of approximately 10 V to approximately 150 V.

8. The method according to any one of claims 4 to 7, wherein the anodic oxidation is conducted at approximately 20°C to approximately 90°C.

9. The method according to any one of claims 1 to 8, wherein the VD is selected from the group consisting of radio frequency magnetron sputtering (RFMS) and plasma-enhanced chemical vapor deposition (PECVD).

10. The method according to any one of claims 1 to 9, wherein the colored precursor is selected from the group consisting of niobium, tantalum, and a combination thereof.

11. The method according to any one of claims 1 to 10, wherein the modified layer comprises the light deflection agent covering an unconverted colored precursor.

12. The method according to claim 11, wherein the light deflection agent and the colored precursor are at a thickness ratio of approximately 90:10 to approximately 60:40.

13. The method according to any one of claims 1 to 12, wherein the preferred color is any one selected from the group consisting of green, purple, orange, iridescence, and a color gradient.

14. The method according to any one of claims 1 to 13, further comprising forming the first substrate by electroplating the metallic material on another metallic material.

15. The method according to any one of claims 1 to 13, further comprising forming the first substrate by plating the metallic material on a non-metallic material.

16. The method according to claim 14, wherein the plating is conducted by electroless plating.

17. The method according to claim 15 or 16, wherein the non-metallic material is selected from the group consisting of a wood material, a plastic, a carbonaceous material, and a combination thereof.

18. The method according to claim 17, wherein the wood material is a wood composite.

19. The method according to claim 17, wherein the plastic is selected from the group consisting of acrylonitrile butadiene styrene (ABS), polyethylene (PE), polypropylene (PP), polyvinyl chloride (PVC), polylactic acid (PLA), and a combination thereof.

20. The method according to claim 17, wherein the carbonaceous material is selected from the group consisting of graphite, carbon fiber, carbon cloth, carbon sheet, and a combination thereof.

21. The method according to any one of claims 1 to 20, wherein the metallic material is selected from the group consisting of stainless steel, brass, copper, titanium, aluminum, palladium, cobalt, an alloy comprising the titanium and the aluminum, an alloy comprising the palladium and the cobalt, and a combination thereof.

22. A method for changing a color of an article, comprising the following steps:
a) providing an article comprising a first substrate, wherein the first substrate comprises a metallic material;
b) depositing a colored precursor layer on the first substrate by VD, such that the colored precursor layer uses a non-planar contour of the first substrate to form a combined substrate with the first substrate; and
c) converting a colored precursor in at least one predetermined portion of the colored precursor layer into a light deflection agent to form a modified layer exhibiting a preferred color.

23. The method according to claim 22, wherein the colored precursor layer has a predetermined thickness of at least approximately 1 µm.

24. The method according to claim 22, wherein the colored precursor in the at least one predetermined portion of the colored precursor layer in step c) is converted into the light deflection agent by anodic oxidation.

25. The method according to claim 24, wherein the anodic oxidation comprises oxidizing the colored precursor into a colored precursor oxide.

26. The method according to claim 24 or 25, wherein the anodic oxidation is conducted for at least 1 min.

27. The method according to any one of claims 24 to 26, wherein the anodic oxidation is conducted at a voltage of approximately 10 V to approximately 150 V.

28. The method according to any one of claims 24 to 27, wherein the anodic oxidation is conducted at approximately 20°C to approximately 90°C.

29. The method according to any one of claims 22 to 28, wherein the VD is selected from the group consisting of RFMS and PECVD.

30. The method according to any one of claims 22 to 29, wherein the colored precursor is selected from the group consisting of niobium, tantalum, and a combination thereof.

31. The method according to any one of claims 22 to 30, wherein the modified layer comprises the light deflection agent covering an unconverted colored precursor.

32. The method according to claim 31, wherein the light deflection agent and the colored precursor are at a thickness ratio of approximately 90:10 to approximately 60:40.

33. The method according to any one of claims 22 to 32, wherein the preferred color is any one selected from the group consisting of green, purple, orange, iridescence, and a color gradient.

34. The method according to any one of claims 22 to 33, further comprising forming the first substrate by electroplating the metallic material on another metallic material.

35. The method according to any one of claims 22 to 33, further comprising forming the first substrate by plating the metallic material on a non-metallic material.

36. The method according to claim 35, wherein the plating is conducted by electroless plating.

37. The method according to any one of claims 22 to 36, wherein the metallic material is selected from the group consisting of stainless steel, brass, copper, titanium, aluminum, palladium, cobalt, an alloy comprising the titanium and the aluminum, an alloy comprising the palladium and the cobalt, and a combination thereof.

38. An article, comprising:
a first substrate having a non-planar contour; and
a second substrate deposited on the first substrate, wherein the second substrate uses the non-planar contour of the first substrate to form a seamlessly bonded substrate with the first substrate;
the second substrate comprises a colored precursor layer covering the first substrate; and
a colored precursor of the colored precursor layer is selected from the group consisting of niobium, tantalum, and a combination thereof.

39. The article according to claim 38, wherein the colored precursor layer has a substantially uniform thickness.

40. The article according to claim 38 or 39, wherein the colored precursor layer has a predetermined thickness of at least approximately 1 µm.

41. The article according to any one of claims 38 to 40, wherein the second substrate further comprises a colored precursor oxide layer covering the colored precursor layer.

42. The article according to claim 41, wherein the colored precursor layer and the colored precursor oxide layer are at a thickness ratio of approximately 90:10 to approximately 60:40.

43. The article according to any one of claims 38 to 42, wherein the article has a color selected from the group consisting of green, purple, orange, iridescence, and a color gradient.

44. The article according to claim 38, comprising a watch, jewelry, and a spectacle frame.

45. The article according to claim 38, wherein the second substrate is deposited on the first substrate by physical vapor deposition (PVD) or chemical vapor deposition (CVD).
